Europäisches Patentamt

European Patent Office

Office européen des brevets

(19)

(11) **EP 1 071 249 B1**

(12) **FASCICULE DE BREVET EUROPEEN**

(45) Date de publication et mention
de la délivrance du brevet:
**28.12.2005 Bulletin 2005/52**

(51) Int Cl.⁷: **H04L 27/20**, H04L 25/03,
H03J 5/02, H04B 1/40,
H03J 5/24

(21) Numéro de dépôt: **00402060.8**

(22) Date de dépôt: **20.07.2000**

(54) **Procédé et dispositif de modulation dans un émetteur**

Verfahren und Vorrichtung zur Modulation in einem Sender

Modulation method and device in a transmitter

(84) Etats contractants désignés:
**AT BE CH CY DE DK ES FI FR GB GR IE IT LI LU
MC NL PT SE**

(30) Priorité: **22.07.1999 FR 9909535**

(43) Date de publication de la demande:
**24.01.2001 Bulletin 2001/04**

(73) Titulaire: **TCL & ALCATEL MOBILE PHONES
LIMITED
China Hong Kong City, 33 Canton Road,
Tsim Sha Tsui,Kowloon, Hong Kong (CN)**

(72) Inventeurs:
• **Savelli, Patrick
75012 Paris (FR)**
• **Kruck, Jean-Francois
59110 La Madeleine (FR)**

(74) Mandataire: **Feray, Valérie et al
Feray Lenne Conseil
39/41, avenue Aristide Briand
92163 Antony (FR)**

(56) Documents cités:
**EP-A- 0 798 880          EP-A- 0 800 283
WO-A-98/25353          WO-A-98/28852
GB-A- 2 320 150**

## Description

La présente invention a pour objet un procédé de modulation dans un émetteur. Elle a également pour objet un émetteur fonctionnant selon ce procédé. L'invention est plus particulièrement destinée à une utilisation avec des émetteurs de type bibande ou plus généralement multibande. A ce titre elle est particulièrement intéressante dans le domaine de la téléphonie mobile lorsqu'il s'agit avec un même émetteur de pouvoir transmettre des signaux selon la norme GSM à 900 MHz, la norme DCS à 1800 MHz, la norme PCS à 1900 MHz, voire la norme UMTS à 2200 MHz. L'invention a pour conséquence immédiate la réduction du nombre d'oscillateurs locaux nécessaires pour un téléphone mobile de type multibande.

Les circuits de modulation utilisés généralement, en émission, en téléphonie mobile comportent dans une boucle de régulation un oscillateur commandé, en général commandé en tension (VCO), par un signal de commande produit par un comparateur de phase. Le comparateur de phase reçoit un signal à une fréquence de référence d'une part et un signal correspondant, après une division de fréquence par N, au signal produit par l'oscillateur commandé en tension d'autre part. De ce fait, la fréquence du signal produit par l'oscillateur commandé en tension est un multiple, par N, de la fréquence du signal de référence.

La fréquence de ce signal de référence est ajustée très précisément, et de préférence à une valeur égale à la différence entre deux canaux de fréquence passant dans une bande de fréquence utile. Pour fixer les idées, dans le cadre du GSM 900 MHz et du DCS 1800 MHz, la séparation entre les canaux est de 200 KHz de sorte que la fréquence de référence est choisie égale à 200 KHz. Dans ces conditions le coefficient N de division utilisé vaut de l'ordre de 4500 dans un cas et de 9000 dans l'autre.

L'aptitude au réglage des oscillateurs commandés en tension des boucles de régulation n'est cependant pas suffisamment importante pour qu'un même oscillateur puisse servir à la fois dans une bande, la bande GSM à 900 MHz, et dans une autre bande, la bande DCS à 1800 MHz (ou PCS, ou UMTS). De ce fait, il est nécessaire de construire une deuxième boucle d'émission avec un deuxième oscillateur local commandé en tension. La solution qui souscrit alors aux normes est donc une solution plus chère parce que par ailleurs un oscillateur local est un circuit qui ne peut pas être intégré et qui en pratique grève très fortement le prix d'un émetteur.

Dans l'invention, une fois qu'on dispose d'un tel signal produit par un seul oscillateur local et qu'on veut que l'émetteur puisse fonctionner d'une manière bibande, on prévoit de placer en cascade, en aval de la boucle de régulation, un diviseur, par exemple un diviseur par deux. En agissant ainsi les fréquences élevées utilisables dans la gamme DCS, PCS ou UMTS peuvent être divisés par deux pour servir de fréquences centrales de canaux dans la gamme GSM 900 MHz. Eventuellement le diviseur peut être un diviseur fractionnaire.

Le document WO 98/25353 est relatif à un appareil de transmission de signaux RF dans deux bandes de fréquence séparées. Une première unité de traitement agencée en sortie d'un VCO est destinée à la sélection de la fréquence de fonctionnement choisie par la multiplication de la fréquence en sortie du VCO d'un facteur k. Une seconde unité de traitement agencée dans la boucle de verrouillage de phase du VCO est destinée à compenser la multiplication de la largeur de bande du signal en sortie de la première unité lorsque celle-ci est activée. Cette compensation est réalisée au moyen d'une multiplication d'un même facteur k.

Cependant, cette solution met en oeuvre un dispositif dans la boucle de verrouillage de phase, ce qui implique une modification matérielle dans la boucle et par conséquent grève le coût de celle-ci.

Ce premier problème étant acquis, il convient en outre de moduler le signal de porteuse ainsi produit. Une solution qui correspond à ce mode de division consiste à placer, en aval du diviseur par deux, un modulateur en bande de base. Ce modulateur est un circuit qui reçoit d'une part le signal de l'oscillateur local régulé, et éventuellement divisé, et d'autre part des signaux de modulation correspondant à un signal de modulation. En pratique, un tel modulateur utilise des mélangeurs, en général deux mélangeurs en quadrature. L'inconvénient d'une telle architecture pourrait être que les mélangeurs situés en sortie soient des circuits bruyants. Le bruit qu'ils produiraient retentirait en des parasites émis dans des canaux adjacents au canal d'émission et surtout émis à des multiples entiers de la fréquence d'émission. De ce fait, lorsqu'on diviserait la fréquence par deux et qu'on exploiterait l'émetteur dans une bande de fréquence inférieure, on produirait des parasites dans la bande de fréquence dont la fréquence est du double de la fréquence centrale de cette bande inférieure. En pratique cette solution peut être mieux mise en oeuvre si on emploie des filtres.

Cependant de tels filtres sont chers. Par ailleurs, la présence d'un duplexeur placé après l'amplificateur peut provoquer des pertes d'insertion et pénaliser la consommation.

Une autre façon de réaliser la modulation permet de s'affranchir des bruits par les mélangeurs lorsque les mélangeurs sont placés en aval de la boucle de régulation. Selon cette deuxième technique, on module le signal de référence lui-même par le signal de modulation à transmettre. De ce fait, le bruit produit par les mélangeurs du circuit de modulation ne passent en aval qu'à travers la boucle de régulation de l'oscillateur commandé en tension. Dans cette boucle est placé un filtre de boucle particulièrement efficace, par exemple avec une bande passante limitée à 10 KHz. Il en résulte immédiatement que le bruit des mélangeurs est filtré par la boucle. Dans ces conditions un signal émis dans une bande de fréquence inférieure, par exemple à 900 MHz dans la bande GSM 900, ne produit pas de bruit dans la bande de réception de 915 MHz à 960 MHz.

L'inconvénient présenté par cette deuxième technique est toutefois qu'elle est incompatible avec l'utilisation d'un diviseur de fréquence situé en aval.

L'invention a pour but de résoudre les problèmes cités ci-dessus et de permettre de choisir une solution comportant les deux avantages de bruit et de coût faible. Dans l'invention, on s'est rendu compte en fait que pour pouvoir utiliser la solution de la deuxième technique, avec un diviseur de fréquence par deux comme dans la première technique ce qui permet d'éviter un nombre trop important d'oscillateurs locaux, il suffisait de changer la fréquence de référence à moduler d'une part et de changer par ailleurs et surtout l'indice de modulation sur lequel un signal à cette fréquence de référence était modulé. Pour simplifier, pour produire un signal à émettre à la fréquence 2F0 (par exemple de l'ordre de 1800 MHz), il suffit d'utiliser un signal de référence à 200 KHz (correspondant à la largeur entre canaux) et à utiliser un coefficient de boucle égal à 9000. Dans ce cas ce signal de référence à 200 KHz peut être modulé simplement. Par contre si, selon l'invention, on veut utiliser le diviseur par deux, pour ramener la fréquence de 1800 MHz à 900 MHz, alors on remplace le signal de référence par un signal à 400 KHz, le coefficient multiplicateur étant alors naturellement de l'ordre de 4500, mais surtout on modifie la profondeur de modulation, c'est-à-dire l'indice de modulation de façon à ce qu'après division le spectre du signal modulé occupe la même largeur utile de 200 KHz autorisée par le canal.

Dans ce cas, on peut aboutir à n'effectuer qu'une simple multiplication de la valeur du signal de modulation. L'amplitude du signal de modulation devient alors multiple de la valeur du signal de modulation qu'on aurait utilisé sans division. La commutation entre un signal à 200 KHz et un signal à 400 KHz est très simple. En pratique, il suffit de produire un signal à 400 KHz et de le diviser, ou non, par deux selon le besoin. On montrera par la suite que la modification de l'indice de modulation est une opération très simple qui compte tenu d'un traitement numérique de la modulation ne retentit en aucune modification matérielle. Elle procure une solution souple à mettre en oeuvre car la modification peut se réaliser de manière programmable. Si le rapport de division est modifié, il suffit de modifier de manière numérique l'indice de modulation. De ce fait, avec l'invention on obtient facilement un émetteur bibande avec exactement les mêmes composants qu'un émetteur monobande. Le coût supplémentaire est donc quasiment nul.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :

- Figure 1 : une représentation du principe de modulation d'un émetteur muni selon l'invention d'un diviseur de fréquence;
- Figure 2 : une représentation schématique du procédé et du dispositif de modulation selon l'invention ;
- Figure 3 : des diagrammes spectraux montrant respectivement la transposition de fréquences selon l'état de la technique, avec l'impossibilité évoquée, et d'autre part le perfectionnement apporté par l'invention ;
- Figure 4 : une représentation d'un exemple préféré de réalisation simple d'une partie d'un dispositif de modulation selon l'invention.

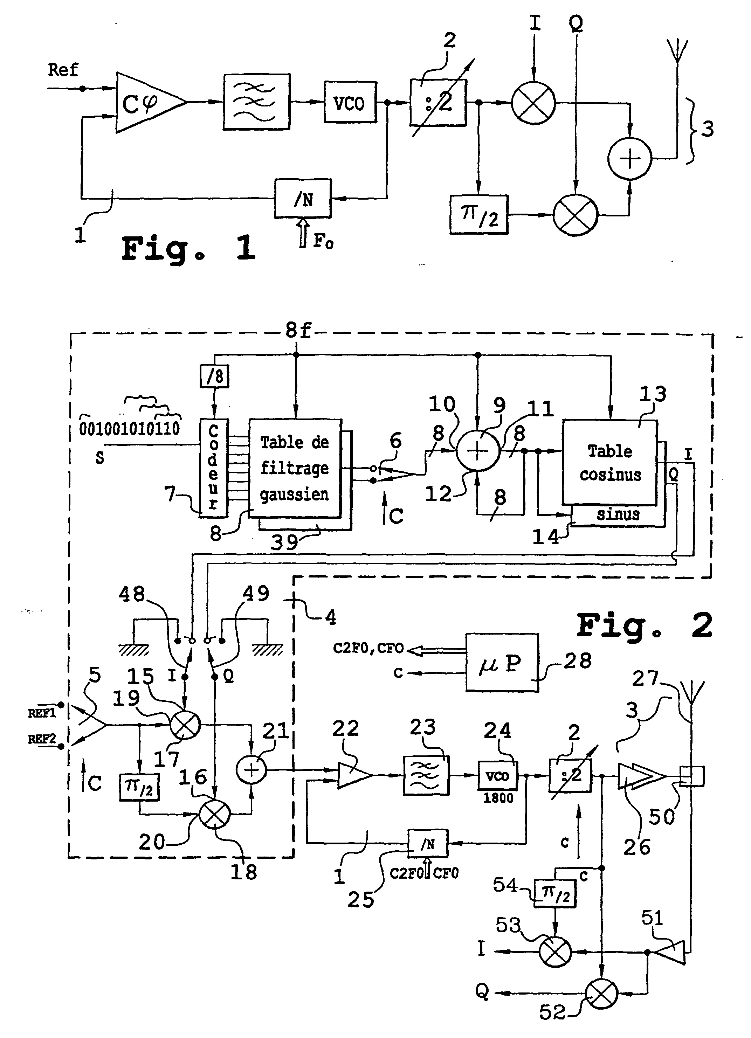

La figure 1 montre un émetteur, un dispositif de modulation, selon l'invention. Ce dispositif de modulation comporte une boucle 1 de régulation comportant ici essentiellement un oscillateur commandé en tension VCO dont l'entrée de commande est reliée, notamment par l'intermédiaire d'un filtre de boucle, à la sortie d'un comparateur de phase C . Le comparateur C reçoit en entrée un signal Ref de référence à comparer à un signal correspondant au signal de sortie de l'oscillateur VCO. Dans la correspondance, la fréquence du signal de l'oscillateur est divisée par un diviseur par N, N étant un entier mais pouvant également être une grandeur fractionnaire. En cascade avec la boucle 1 est présent un circuit 3 d'émission radioélectrique, ici simplement figuré par une antenne. Selon l'invention, un circuit 2 de division optionnelle est interposé entre la boucle 1 et le circuit 3. Le circuit 2 modifie par division la fréquence du signal délivré par l'oscillateur VCO de la boucle 1. Dans un exemple préféré, la division du diviseur 2 est une division par deux. Cette division est optionnelle en ce sens qu'elle est commandée par un signal de commande et effectuée à la demande, quand on veut que la fréquence du signal émis par le circuit 3 soit changée. Par exemple cette fréquence est changée pour passer d'une fréquence située dans la gamme DCS à 1800 MHz à une fréquence située dans la gamme GSM à 900 MHz. En agissant ainsi, l'oscillateur VCO sert aussi bien pour une gamme que pour l'autre. L'exploration en fréquence de cet oscillateur VCO commun doit correspondre à l'exploration la plus importante entre l'exploration dans la gamme de fréquence supérieure et le double de l'exploration dans la gamme de fréquence inférieure.

Dans la variante représentée sur la figure 1, le signal à émettre est modulé par des signaux de modulation I et Q agissant sur un modulateur situé en aval du diviseur 2, et en amont du circuit 3. Une telle réalisation peut requérir la présence de filtres, non représentés, à interposer entre le modulateur et le circuit 3 d'émission. Pour éviter la présence de ces filtres, ou pour en utiliser des plus simples, on peut procéder différemment.

La figure 2 montre à cet égard un dispositif de modulation selon un perfectionnement de l'invention. Ce dispositif permet de mettre en oeuvre le procédé de l'invention. Ce dispositif de modulation comporte en cascade la boucle de régulation 1, le circuit 2 de division optionnelle et le circuit 3 d'émission radioélectrique. Selon une caractéristique essentielle de ce perfectionnement de l'invention, le dispositif de modulation comporte un circuit de modulation 4 pour moduler un signal de référence admis en entrée de la boucle de régulation 1. Ici, comme cela sera expliqué plus loin, le signal de référence est soit un signal de référence REF1, soit un signal de référence REF2. Dans un exemple le signal REF1 sera un signal sinusoïdal pur à 200 KHz utilisable dans la gamme DCS 1800 MHz ou PCS voire UMTS alors que le signal de référence REF2 sera un signal sinusoïdal pur à une fréquence de 400 KHz.

Dans ce but le circuit de modulation comporte un premier commutateur 5 pour choisir un signal de référence avec une première, REF1, ou une deuxième, REF2, fréquence. En pratique, il est possible de produire un seul signal de référence, par exemple celui à la fréquence REF2 et de diviser, ou non, le signal à cette deuxième fréquence par un coefficient pour obtenir le signal à la fréquence REF1. Le fait de diviser ou non sera de la même façon obtenu par une commutation. La division par deux envisagée ici est une solution préférée. D'autres divisions seraient envisageables en relation avec la valeur de division du diviseur 2 et en relation avec la largeur de canal institué dans chacune des bandes.

Selon une autre caractéristique essentielle, le circuit de l'invention comporte un deuxième commutateur 6 pour commuter des caractéristiques de modulation d'un signal S de modulation.

Le fonctionnement de cet ensemble est le suivant. Comme indiqué dans le livre: "Réseaux GSM et DCS" de MM. Xavier LAGRANGE, Philippe GODELEWSKI, Sami TABBANE troisième édition revue et augmentée, Editions Hermès, Paris 1997, pages 196-200, dans le cadre d'une modulation de type GMSK on utilise un filtre gaussien passe-bas en amont d'un modulateur de fréquence. Le circuit 4 comporte ici un tel filtre et un tel modulateur de fréquence. Le filtre n'est pas a priori indispensable pour l'invention bien qu'il apporte une bonne protection du signal transmis vis-à-vis des bruits du canal et une meilleure utilisation des propriétés des circuits de décodage en réception. Dans un exemple, le signal S de modulation, à transmettre, se présente sous la forme d'une succession de signaux binaires, représentés conventionnellement par des zéros et des uns. Dans la pratique ces signaux sont produits à une fréquence normalisée f, correspondant à 270,833 kbits/s en GSM et PCS par exemple. Ces signaux sont introduits dans un codeur 7 possédant un certain nombre de sorties reliées à des entrées d'adresse d'une table de conversion 8. D'une manière connue, la table précalculée de conversion 8 effectue un filtrage, en particulier un filtrage de type gaussien. Néanmoins on pourrait se passer de ce filtrage, ou bien ce filtrage pourrait être un filtrage identité. La table 8 est reliée en sortie à un accumulateur de phase 9. Cet accumulateur de phase est un additionneur numérique capable d'additionner un signal transmis à une première de ses entrées 10 à un signal produit par sa sortie 11 et réintroduit sur une deuxième de ses entrées 12 au rythme d'un signal de commande.

Alors que le signal S est produit avec une fréquence f correspondant au débit cité ci-dessus, l'accumulateur 9 sera de préférence commandé par un signal à une fréquence suréchantillonée par exemple de 8f. Qu'il y ait ou non suréchantillonnage, le signal disponible en sortie de l'accumulateur 9 sert d'entrée d'adresse à deux tables de conversion, respectivement 13 et 14, effectuant les transformations de type cosinus et sinus respectivement et produisant des signaux I et Q de type connu. Ces signaux I et Q sont transformés en signaux analogiques et sont appliqués sur des premières entrées 15 et 16 de deux mélangeurs 17 et 18 respectivement. Les mélangeurs 17 et 18 reçoivent par ailleurs sur des deuxièmes entrées 19 et 20 respectivement le signal de référence REF1 (ou REF2) et ce même signal de référence déphasé de 90°. Les sorties des mélangeurs 17 et 18 sont reliées à un additionneur 21 dont la sortie est utilisée comme entrée de consigne d'un comparateur de phase 22 de la boucle 1.

Le signal délivré par le comparateur 22 est transmis à un filtre de boucle 23, par exemple passebas à 200 KHz. Le signal issu du filtre 23 est appliqué comme entrée de commande à un oscillateur local 24 commandé en tension. Le signal produit par l'oscillateur local est rebouclé sur une deuxième entrée du comparateur de phase 22 par l'intermédiaire d'un diviseur 25 par N. La valeur N vaut autour de 4500 ou 9000 selon le type d'émission choisie. La valeur N saute d'une ou plusieurs unités selon un canal F0 ou 2F0 à obtenir. Ces indications concernent la norme GSM, pour un synthétiseur classique. Mais les valeurs de N peuvent être différentes. D'une manière générale, l'invention peut être mise en oeuvre pour différentes structures de boucle, notamment à division fractionnaire. En variante, notamment en cas de division fractionnaire, le signal à moduler pourrait être le signal issu de l'oscillateur 24.

Le circuit d'émission 3 comporte en outre d'une manière connue un amplificateur de puissance 26 et un aérien de rayonnement 27.

Le fonctionnement du perfectionnement de l'invention est le suivant. Lorsqu'on veut émettre dans la gamme de fréquence haute, par exemple autour de 1800 MHz, avec une fréquence d'émission égale à 2F0, un circuit de commande 28 comportant notamment un microprocesseur produit d'une part un signal de commande C2F0 pour commander le diviseur 25, et d'autre part un signal C pour commander les commutateurs 5 et 6. Pour simplifier l'explication on pourra admettre que la fréquence du signal 2F0 vaut 1800 MHz. Dans ces conditions, dans un état, le commutateur 5 est placé dans une position telle qu'il accueille le signal sinusoïdal pur REF1, à 200 KHz. Hormis la modulation, la multiplication de la boucle 1 conduit à disposer en sortie d'un signal à 1800 MHz (200 x 9000). Le signal modulant est traité d'une manière connue dans les circuits 7 à 20. Dans ce cas, le commutateur 6 correspond à une table de filtrage 8 classique.

Lorsqu'on veut utiliser l'émetteur représenté selon une autre gamme, par exemple dans la gamme GSM 900 autour de 900 MHz, le circuit 28 produit un ordre CF0 pour commander le diviseur 25, par exemple par une division par 4500. L'ordre C est tel qu'il commute les commutateurs 5 et 6 et qu'il met par ailleurs en service le diviseur optionnel par deux. En conséquence le signal introduit dans la boucle 1 est le signal REF2 (à la modulation près) soit approximativement dans l'exemple préféré 400 KHz. Avec la boucle et le multiplicateur N par 4500, on obtient à nouveau en sortie de l'oscillateur 24 un signal à 1800 MHz. Cependant, dans le cas présent selon les différentes valeurs possibles pour CF0 (qui saute d'unité en unité autour de 4500), le signal produit par l'oscillateur 24 saute par des sauts de 400 KHz autour de 1800 MHz. Dans ces conditions, la division par deux amène à disposer d'un signal sautant par sauts de 200 KHz autour de 900 MHz. C'est ce qui était recherché.

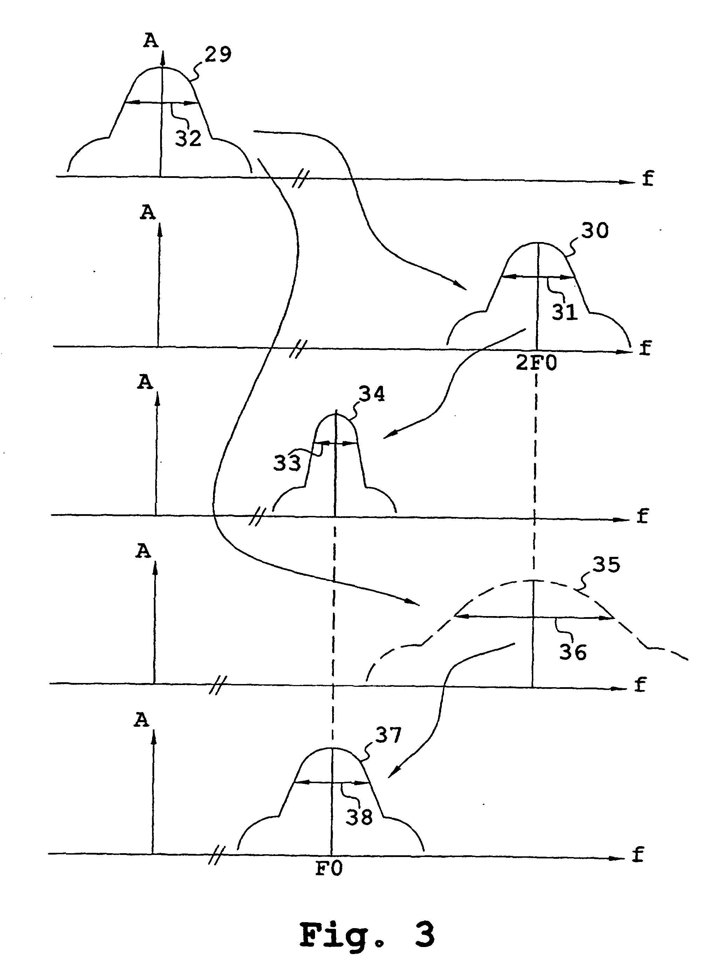

La figure 3 va montrer l'intérêt selon l'invention de changer de table de filtrage ou, plus généralement, de changer d'indice de modulation du signal modulant le signal de référence. Sur celle-ci, dans le diagramme supérieur on a montré en bande de base un spectre 29 d'un signal ayant 200 KHz de bande utile. Le diagramme situé en dessous montre un spectre 30 transposé autour de 2F0 (sensiblement 1800 MHz) dont la largeur 31 est égale à la largeur utile 32 du spectre 29. Le diagramme situé juste en dessous montre que si on avait utilisé le diviseur par deux dans ces conditions, la largeur 33 du spectre 34 résultant serait deux fois moins large que la largeur 31. En pratique la réduction n'étant pas linéaire, le spectre 34 est moins large, tout en n'étant pas deux fois moins large. Par opposition dans l'invention, diagramme situé encore en dessous, lorsqu'on veut utiliser la division par deux on commence par produire un signal modulant qui, s'il était utilisé tel quel pour moduler le signal de sortie de l'oscillateur 24 conduirait à un spectre 35 dont la largeur utile 36 serait du double, 400 KHz dans un exemple, de la largeur autorisée 31 du spectre 30. De même que ci-dessus, l'augmentation n'est pas du double. Dans les faits, le spectre 35 est celui disponible en sortie de l'oscillateur 24 avant le diviseur par deux 2. Au moment de la division par deux, le spectre 35 se déplace en un spectre 37 de largeur 38 égale à la largeur 31 et à la largeur 32 attendue.

Ceci est obtenu, en théorie en passant de

$$s(t) = A_p(t) \cos(h.2\pi f0t) - A_q(t) \sin(h.2\pi f0t)$$

à

$$s(t) = A_p(t) \cos(2h.2\pi f0t) - A_q(t) \sin(2h.2\pi f0t)$$

Dans ces expressions $A_p(t)$ et $A_q(t)$ sont les composantes en phase et en quadrature du signal modulé. Le signal modulant et le signal h.2πf0t. Selon la position du commutateur 6, la valeur du paramètre vaut h ou 2h. Ceci revient à doubler la fréquence de modulation. Dans l'invention on a trouvé une solution particulièrement simple pour doubler la fréquence de modulation.

En pratique, avec un accumulateur de phase, il suffit de doubler la valeur du signal modulant (et non pas sa fréquence). Dans le cas de l'utilisation d'une table de filtrage 8 qui de préférence est une table de filtrage gaussien, on peut prévoir de dupliquer son contenu. De cette manière on dispose de sous-tables, la sous-table 8 déjà envisagée, et une sous-table 39. Les contenus des cellules mémoires de la sous-table 39 sont des valeurs doubles de celle des cellules mémoires de la sous-table 8. De ce fait, même si la fréquence f d'échantillonnage (ou de suréchantillonnage 8f) de l'accumulateur de-phase 9 n'est pas modifié (ce qui signifie que l'architecture du circuit n'est pas modifiée), on peut obtenir le résultat de l'invention en ne faisant que doubler les valeurs introduites sur l'entrée 10 de cet accumulateur de phase 9. Du fait de la présence de cet accumulateur de phase, le doublement de l'indice de modulation qui conduit au spectre 35 de largeur 36 est réalisé par un doublement de la valeur du signal modulant, dont la fréquence ne change pas. En variante on pourrait aussi modifier la fréquence de commande de l'accumulateur de phases.

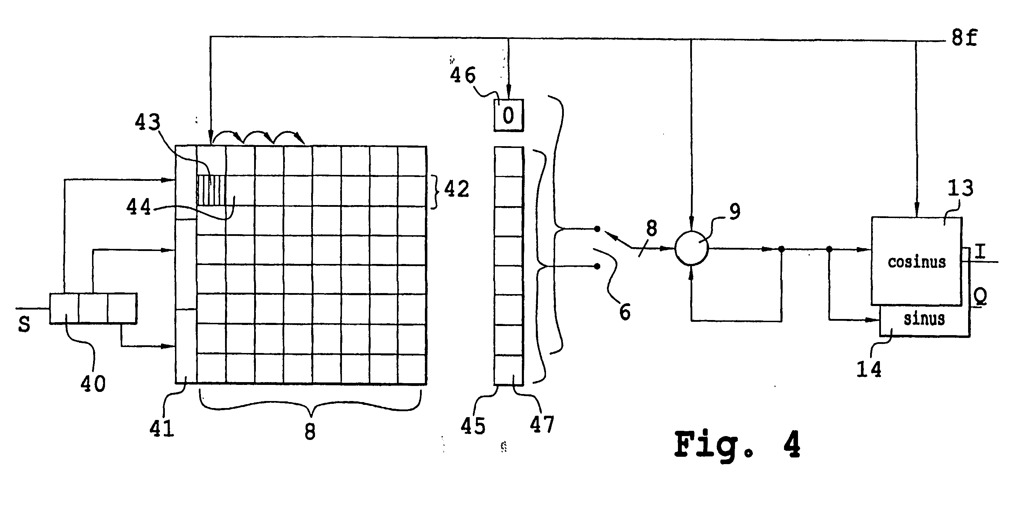

La figure 4 montre un exemple particulièrement intéressant de réalisation de l'ensemble codeur 7, sous-tables 8 et 39 et commutateur 6. Dans celle-ci, le codeur 7 est remplacé par un registre à décalage 40, par exemple à trois cases. Ceci conduit en définitive à réaliser un filtrage de préférence gaussien sur une durée de trois symboles du signal modulant S admis dans le registre 40. Les symboles du signal S sont transmis par le registre 40 sur des entrées d'un décodeur 41 d'adresses de la table 8. Chaque adressage conduit à la sélection d'une série 42 d'enregistrements tels que 43. Chaque enregistrement tel que 43 comporte un mot mémoire, précalculé, avec un nombre M de bits correspondant à une précision du calcul voulue, par exemple 13 bits. On n'a cependant ici représenté que des mots de 8 bits pour la simplification du dessin. A chaque période du signal de suréchantillonnage 8f, un enregistrement 44 suivant un enregistrement précédent 43 est lu dans la série 42. La lecture de chaque enregistrement s'effectue par une transmission du mot mémoire lu à un registre de sortie 45 comportant autant, M, de cellules qu'il y a de bits dans le mot mémoire (43, 44 et suivants). A chaque période du signal f on change de série 42.

Lorsqu'on veut effectuer la modulation du signal de référence REF1 (à 200 KHz), on prélève dans le registre 45 les M - 1 bits de poids forts et on ajoute comme bit de poids le plus fort un poids nul produit par une cellule spéciale 46 du registre 45. Le contenu de la cellule 46 reste inchangé à chaque lecture 43, 44 et suivantes. Cette opération revient à diviser par deux la valeur contenue dans la table 8. En contrepartie, si on veut moduler le signal de référence REF2 à 400 KHz, on utilisera l'ensemble des M bits fournis par le registre 45, sans perdre le bit de poids faible 47. En agissant ainsi, on peut ne pas avoir à réaliser de sous-tables 8 et 39 mais uniquement une table 8. On peut ensuite adresser les tables de conversion 13 et 14 par un bus identique, ici schématiquement représenté avec huit fils.

Etant donné que dans le premier cas M - 1 bits seulement sont significatifs, la résolution de conversion par les tables 13 et 14 sera dégradée dans ce premier cas. Afin de l'éviter, on peut prévoir tout simplement de précalculer les valeurs de la table 8 sur un nombre M + 1 plus important de bits, par exemple 14 bits dans l'exemple préféré. Dans ce cas chacun des enregistrements 43 des séries 42 comporterait des mots de M + 1 bits. Selon qu'on applique aux tables 13 ou 14 un mot comportant la cellule 46 ou la cellule 47, on aura extrait des premières ou des deuxièmes valeurs de la table 8 de filtrage. Les deuxièmes valeurs se déduisent des premières par un décalage, et en particulier par l'ajout d'un zéro. On aurait pu autrement utiliser une seule sous-table 8 et procéder à une multiplication par deux préalablement avant l'accumulation dans l'accumulateur de phase 9. Le commutateur 6 représenté ce prélèvement différent ou bien l'existence ou non de cette multiplication.

En réception, figure 2, la même boucle 1 de régulation peut également servir. Dans ce cas on ajoute deux commutateurs respectivement 48 et 49 afin de pouvoir appliquer sur les entrées 15 et 16 des mélangeurs 17 et 18 des signaux nuls. Par exemple on les raccorde à la masse. Dans ce cas on choisit soit la référence REF1 soit la référence REF2 avec un coefficient diviseur N correspondant de manière à produire en sortie de l'oscillateur 24 un signal pur, non modulé. L'aérien 27 est alors connecté par l'intermédiaire d'un duplexeur 50 à un préamplificateur 51. Le préamplificateur 51 a une sortie reliée à deux premières entrées de deux mélangeurs 52 et 53 qui reçoivent sur deux deuxièmes entrées le signal produit par l'oscillateur 24, en phase ainsi qu'en quadrature de phase par l'intermédiaire d'un déphaseur 54. On produit de cette façon des signaux I et Q démodulés. Il reste à les décoder pour en extraire un signal S auquel ils correspondent.

Cette solution particulièrement simple correspond avantageusement à une réalisation du dispositif de modulation sous une forme intégrée.

## Revendications

**1.** Procédé de modulation dans un émetteur émettant à la demande un signal radioélectrique dans une première ou dans une deuxième bande de fréquences, du type comportant les étapes consistant à :

- produire un signal de référence,
- comparer, dans un comparateur de phase (22), une phase d'un signal d'un oscillateur local (24) avec une phase du signal de référence,
- réguler (1) la fréquence du signal de l'oscillateur local en commandant cet oscillateur local avec un signal issu du comparateur de phase,
- modifier (2), à la demande (C), la fréquence ainsi régulée du signal de l'oscillateur local par division par un coefficient N avec un diviseur de fréquence pour que la fréquence corresponde à la première bande ou à la deuxième bande et on produit ainsi un signal à fréquence modifiée,

**caractérisé en ce que**
à la demande (C), le procédé comprend les étapes suivantes:

- moduler selon un premier indice (8) de modulation un premier signal (REF1) de référence avec un signal de modulation pour servir de signal de référence, ou
- moduler selon un deuxième indice (39) de modulation un deuxième signal (REF2) de référence avec le signal de modulation pour servir de signal de référence,

les signaux de référence (REF1, REF2) et les indices de modulation étant respectivement déterminés de manière à compenser la variation de la largeur de bande dudit signal à fréquence modifiée générée par la division par le coefficient N.

**2.** Procédé selon la revendication 1, **caractérisé en ce que**, à la demande, le coefficient N est égal à deux.

**3.** Procédé selon la revendication 1 ou 2, **caractérisé par** les étapes de :

- moduler les signaux de référence avec une chaîne de modulation comportant en cascade une table (8, 39) numérique de filtrage lue en fonction des variations (f) du signal de modulation, un accumulateur (9) de phase et un jeu de tables (13, 14) de conversion, et
- à la demande, extraire (6) des premières valeurs ou des deuxièmes valeurs de la table de filtrage.

**4.** Procédé selon la revendication 3, **caractérisé en ce que** l'étape d'extraction consiste à traiter à la demande des valeurs lues dans la table de filtrage par un décalage (46, 47).

5. Procédé selon la revendication 3, **caractérisé en ce que** l'étape d'extraction consiste à traiter à la demande des valeurs lues dans la table de filtrage par une multiplication.

6. Procédé selon la revendication 3, **caractérisé en ce que** l'étape d'extraction consiste à lire à la demande des valeurs dans une première (8) ou une deuxième (39) sous-table de la table de filtrage.

7. Dispositif de modulation comportant en cascade une boucle (1) de régulation de fréquence munie d'un comparateur (22) de phase et un circuit (3) d'émission radioélectrique, comportant un circuit (2) de division optionnelle par un coefficient N interposé entre la boucle et le circuit d'émission, **caractérisé en ce que**

   le dispositif comporte un circuit (4) de modulation d'un signal de référence admis en entrée de la boucle de régulation par un signal de modulation, un premier circuit (5) de commutation pour choisir une fréquence du signal de référence entre une première (REF1) et une deuxième (REF2) fréquence, et un deuxième circuit (6) de commutation pour commuter des indices de modulation du signal de modulation,
   les signaux de référence (REF1, REF2) et les indices de modulation étant respectivement déterminés de manière à compenser la variation de la largeur de bande du signal à fréquence modifiée générée par la division par le coefficient N.

8. Dispositif selon la revendication 7, **caractérisé en ce que** le circuit de division optionnelle est un circuit de division par deux.

9. Dispositif selon la revendication 7 ou 8, **caractérisé en ce que** le deuxième circuit de commutation comporte un circuit (46, 47) de décalage de la lecture d'une table (8) de filtrage du signal de modulation.

10. Dispositif selon l'une des revendications 7 à 9, **caractérisé en ce que** le circuit de modulation comporte deux commutateurs (48, 49) pour commuter le dispositif d'un mode d'émission à un mode de réception.

**Patentansprüche**

1. Modulationsverfahren in einem Sender, der nach Bedarf ein Hochfrequenzsignal in einem ersten oder in einem zweiten Frequenzband sendet, wobei das Verfahren von dem Typ ist, der die Schritte umfasst, die darin bestehen:

   - ein Referenzsignal zu erzeugen,
   - in einem Phasenkomparator (22) eine Phase eines Hilfsoszillatorsignals (24) mit einer Phase des Referenzsignals zu vergleichen,
   - die Frequenz des Hilfsoszillatorsignals zu regulieren, indem dieser Hilfsoszillator mit einem von dem Phasenkomparator ausgegebenen Signal gesteuert wird,
   - nach Bedarf (C) die somit regulierte Frequenz des Hilfsoszillatorsignals durch Division mit einem Koeffizienten N mittels eines Frequenzteilers zu modifizieren (2), damit die Frequenz dem ersten Band oder dem zweiten Band entspricht und auf diese Weise ein Signal mit modifizierter Frequenz erzeugt wird,

   **dadurch gekennzeichnet, dass**
   das Verfahren nach Bedarf (C) die folgenden Schritte umfasst:

   - Modulieren gemäß einem ersten Modulationsindex (8) eines ersten Referenzsignals (REF1) mit einem Modulationssignal, damit es als Referenzsignal dient, oder
   - Modulieren gemäß einem zweiten Modulationsindex (39) eines zweiten Referenzsignals (REF2) mit dem Modulationssignal, damit es als Referenzsignal dient,

   wobei die Referenzsignale (REF1, REF2) und die Modulationsindizes jeweils in der Weise bestimmt werden, d.ass die Schwankung der Bandbreite des Signals mit modifizierter Frequenz, die durch Division mit dem Koeffizienten N erzeugt wird, kompensiert wird.

2. Verfahren nach Anspruch 1, **dadurch gekennzeichnet, dass** nach Bedarf der Koeffizient N gleich zwei ist.

3. Verfahren nach Anspruch 1 oder 2, **gekennzeichnet durch** die folgenden Schritte:

   - Modulieren der Referenzsignale mit einer Modulationskette, die in Kaskade eine in Abhängigkeit von den Schwankungen (f) des Modulationssignals gelesene digitale Filterungstabelle (8, 39), einen Phasenakkumulator (9) und einen Satz von Umsetzungstabellen (13, 14) umfasst, und
   - nach Bedarf Extrahieren (6) erster Werte oder zweiter Werte aus der Filterungstabelle.

4. Verfahren nach Anspruch 3, **dadurch gekennzeichnet, dass** der Extraktionsschritt darin besteht, nach Bedarf in der Filterungstabelle gelesene Werte durch Verschieben (46, 47) zu bearbeiten.

**5.** Verfahren nach Anspruch 3, **dadurch gekennzeichnet, dass** der Extraktionsschritt darin besteht, nach Bedarf in der Filterungstabelle gelesene Werte durch eine Multiplikation zu bearbeiten.

**6.** Verfahren nach Anspruch 3, **dadurch gekennzeichnet, dass** der Extraktionsschritt darin besteht, nach Bedarf werte in einer ersten (8) oder in einer zweiten (39) Untertabelle der Filterungstabelle zu lesen.

**7.** Modulationsvorrichtung, die in Kaskade eine Frequenzregulierungsschleife mit einem Phasenkomparator (22) und eine Hochfrequenzsendeschaltung (3) sowie eine zwischen die Schleife und die Sendeschaltung eingefügte Schaltung (22) zum optionalen Teilen mit einem Koeffizienten N umfasst, **dadurch gekennzeichnet, dass**

die Vorrichtung eine Schaltung (4) zum Modulieren eines dem Eingang der Regulierungsschleife zugeführten Referenzsignals mit einem Modulationssignal, eine erste Umschaltschaltung (5) zum Auswählen einer Frequenz des Referenzsignals aus einer ersten Frequenz (REF1) und aus einer zweiten Frequenz (REF2) sowie eine zweite Umschaltschaltung (6) zum Umschalten der Modulationsindizes des Modulationssignals umfasst,

wobei die Referenzsignale (REF1, REF2) und die Modulationsindizes jeweils in der Weise bestimmt sind, dass die Schwankung der Bandbreite des Signals mit modifizierter Frequenz, die durch die Division mit dem Koeffizienten N erzeugt wird, kompensiert wird.

**8.** Vorrichtung nach Anspruch 7, **dadurch gekennzeichnet, dass** die Schaltung zum optionalen Teilen eine Teilerschaltung durch zwei ist.

**9.** Vorrichtung nach Anspruch 7 oder 8, **dadurch gekennzeichnet, dass** die zweite Umschaltschaltung eine Schaltung (46, 47) zum Verschieben des Lesens einer Filterungstabelle (8) des Modulationssignals umfasst.

**10.** Vorrichtung nach einem der Ansprüche 7 bis 9, **dadurch gekennzeichnet, dass** die Modulationsschaltung zwei Umschalter (48, 49) umfasst, um die Vorrichtung von einer Sendebetriebsart in eine Empfangsbetriebsart umzuschalten.

**Claims**

**1.** A method for modulating in a transmitter, transmitting on demand, a radio-electric signal in a first or second band of frequencies, of the type including the steps consisting of:

- producing a reference signal,
- comparing, in a phase comparator (22), a phase of a signal from a local oscillator (24) with a phase of the reference signal,
- controlling (1) the frequency of the signal of the local oscillator by controlling this local oscillator with a signal from the phase comparator,
- changing (2) on demand (C), the thereby controlled frequency of the signal of the local oscillator by division by a coefficient N with a frequency divider so that the frequency corresponds to the first band or to the second band, and a signal with a changed frequency is thereby produced,

**characterized in that**
on demand (C), the method comprises the following steps:

- modulating according to a first modulation index (8) a first reference signal (REF1) with a modulation signal to be used as reference signal, or
- modulating according to a second modulation index (39) a second reference signal (REF2) with the modulation signal to be used as reference signal,

the reference signal (REF1, REF2) and the modulation indices being respectively determined in order to compensate the change in bandwidth of said signal with a changed frequency generated by the division by the coefficient N.

**2.** The method according to claim 1, **characterized in that**, on demand, the coefficient N is equal to two.

**3.** The method according to claim 1 or 2, **characterized by** the steps of:

- modulating the reference signals with a modulation chain including as a cascade, a filtering digital table (8, 39) read according to changes (f) in the modulation signal, a phase accumulator (9) and a set of conversion tables (13, 14) and
- on demand, extracting (6) the first values or the second values of the filtering table.

**4.** The method according to claim 3, **characterized in that** the extraction step consists of processing on demand values read in the filtering table by shifting (46, 47).

**5.** The method according to claim 3, **characterized in that** the extraction step consists of processing on demand values read in the filtering table by a multiplication.

6. The method according to claim 3, **characterized in that** the extraction step consists of reading on demand values in a first (8) or second (39) sub-table of the filtering table;

7. A modulation device including as a cascade, a frequency control loop (1) provided with a phase comparator (22) and a radio-electric transmission circuit (3), including an optional division circuit (2) by a coefficient N, interposed between the loop and the transmission circuit,
   **characterized in that**
   the device includes a circuit (4) for modulating a reference signal admitted as an input to the control loop by a modulation signal, a first switching circuit (5) for selecting a frequency of the reference signal between a first (REF1) and a second (REF2) frequency, and a second switching circuit (6) for switching modulation indices of the modulation signal,
   the reference signals (REF1, REF2) and the modulation indices being respectively determined so as to compensate the change in the bandwidth of the signal with a changed frequency, generated by the division by coefficient N.

8. The device according to claim 7, **characterized in that** the optional division circuit is a circuit for division by two.

9. The device according to claim 7 or 8, **characterized in that** the second switching circuit includes a circuit (46, 47) for shifting the reading of a filtering table (8) of the modulation signal.

10. The device according to any of claims 7 to 9, **characterized in that** the modulation circuit includes two switches (80, 49) for switching the device from a transmission mode to a receiving mode.

**Fig. 1**

**Fig. 2**

Fig. 3

Fig. 4

EP 1 071 249 B1